# EUROPEAN PATENT APPLICATION

(11) **EP 1 460 888 A1**
(43) Date of publication of application: **22.09.2004**
(21) Application number: 04006246.5
(22) Date of filing: 16.03.2004
(51) Int. Cl.: H05K 1/18, H05K 3/12, H01L 21/60, H01L 21/48

(54) **Low-profile electronic circuit module and method for manufacturing the same**

(30) Priority: 20.03.2003 JP 2003078121
(71) Applicant: ALPS ELECTRIC CO., LTD., Tokyo 145-8501 (JP)
(72) Inventor: Hirose, Yoshitaka c/o Alps Electric Co., Ltd., Tokyo 145-8501 (JP)
(74) Representative: Klunker . Schmitt-Nilson . Hirsch

(57) **Abstract**

A circuit board (2) having lands (5a,5b) provided on the top surface of the circuit board (2) and the bottom surface of a recess (2a) formed in the top surface and a metal mask (6) having a projection (6a) on the bottom surface thereof are prepared. The metal mask (6) is placed on the circuit board (2) such that the projection (6a) comes into contact with the bottom surface of the recess (2a), and solder cream (8) is applied to the lands (5a,5b) using the metal mask (6). Then, chip components (3) and a flip chip IC (4) are placed on the solder cream (8), and the circuit board (2) is put into a reflow oven where the solder cream (8) is melted and solidified so that external terminals of the chip components (3) are reflow-soldered on the lands (5a) on the top surface of the circuit board (2) and solder balls (4a) of the flip chip IC (4) are reflow-soldered on the lands (5b) on the bottom surface of the recess (2a).

## Description

### BACKGROUND OF THE INVENTION

### 1. Field of the Invention

The present invention relates to electronic circuit modules in which various surface-mount electronic components are soldered on a circuit board and methods for manufacturing the electronic circuit modules. More specifically, the present invention relates to an electronic circuit module in which the surface-mount electronic components include chip components, such as a chip resistor and a chip capacitor, and a flip chip IC of a ball grid array (BGA) type or a bump chip carrier (BCC) type and a method for manufacturing the electronic circuit module.

### 2. Description of the Related Art

Recently, the size of electronic devices has been reduced and electronic circuit modules in which surface-mount electronic components, such as chip components and semiconductor integrated circuit (IC) components, are mounted on a circuit board at high density have been developed.

As a first example of such an electronic circuit module, Japanese Unexamined Patent Application Publication No. 7-211854 discloses, in page 2 and Fig. 6, a module in which chip components and a flip chip IC are reflow-soldered on a plurality of lands arranged on the surface of a circuit board. When the electronic circuit module is manufactured, solder cream is applied to each of the lands on the circuit board using a metal mask, and the chip components and the flip chip IC are placed on the solder cream. Then, the circuit board is put in a reflow oven so that the chip components and the flip chip IC are reflow-soldered on the corresponding lands.

In addition, as a second example, an electronic circuit module in which the circuit components mounted on the circuit board include chip components which are reflow-soldered on lands and an IC bare chip which is adhered to the circuit board and is connected to the lands by wire bonding or with stud bumps is also known in the art.

In the electronic circuit module according to the first example in which the chip components and the flip chip IC are reflow-soldered, the thickness of the electronic circuit module is determined by the height of the flip chip IC which projects from the surface of the circuit board since the flip chip IC is larger than the chip components. Therefore, there is a limit to reducing the thickness of the electronic circuit module for this reason.

In comparison, the thickness of the electronic circuit module according to the second example in which the IC bare chip is mounted on the circuit board can be reduced since the height of the bare chip is sufficiently small relative to that of the flip chip IC. However, since the bare chip cannot be reflow-soldered like the chip components, it must be connected to the lands by wire bonding or with stud bumps. Accordingly, the manufacturing process is complex and an expensive mounting machine is required. Thus, there is a problem in that the total cost of the electronic circuit module increases.

### SUMMARY OF THE INVENTION

In view of the above-described situation, an object of the present invention is to provide an inexpensive, low-profile electronic circuit module.

In order to attain this object, an electronic circuit module according to the present invention includes a circuit board having a recess in a surface of the circuit board; lands which are arranged on the surface of the circuit board and the bottom surface of the recess; and surface-mount electronic components which are reflow-soldered on the lands.

In the electronic circuit module which is constructed as described above, even when one of the surface-mount electronic components which is mounted on the bottom surface of the recess has a greater height than the other surface-mount electronic components, the amount by which the surface-mount electronic component mounted on the bottom surface of the recess projects from the surface of the circuit board is reduced by the amount corresponding to the depth of the recess. Therefore, the thickness of the electronic circuit module can be reduced. In addition, since the surface-mount electronic components are reflow-soldered on the lands arranged on the surface of the circuit board and the bottom surface of the recess, all of the surface-mount electronic components can be attached to the circuit board in a single reflow-soldering process. Therefore, the manufacturing cost can be reduced and an inexpensive electronic circuit module can be obtained. In the electronic circuit module, preferably, the surface-mount electronic component mounted on the bottom surface of the recess is a flip chip IC and the other surface-mount electronic components which are mounted on the surface of the circuit board are chip components.

In addition, in order to attain the above-described object, a method for manufacturing an electronic circuit module according to the present invention includes the steps of forming a recess in a surface of a circuit board; providing lands on the surface of the circuit board and the bottom surface of the recess; placing a metal mask on the surface of the circuit board, the metal mask having a flat top surface and a bottom surface provided with a projection, and positioning the projection with respect to the recess; applying solder cream to each of the lands through the metal mask; placing surface-mount electronic components on the lands with the solder cream interposed between each of the surface-mount electronic components and the corresponding lands; and putting the circuit board in a reflow oven and reflow-soldering the surface-mount electronic components to the corresponding lands.

In the electronic circuit module which is manufactured by the above-described method, the solder cream is applied to each of the lands arranged on the surface of the circuit board and the bottom surface of the recess using a metal mask having a projection. Then, the surface-mount electronic components are placed on the solder cream and are reflow-soldered on the corresponding lands. Accordingly, all of the surface-mount electronic components can be attached to the circuit board in a single reflow-soldering process. Therefore, the manufacturing cost can be reduced and an inexpensive electronic circuit module can be obtained. In addition, even when one of the surface-mount electronic components which is mounted on the bottom surface of the recess has a greater height than the other surface-mount electronic components, the amount by which the surface-mount electronic component mounted on the bottom surface of the recess projects from the surface of the circuit board is reduced by the amount corresponding to the depth of the recess. Therefore, the thickness of the electronic circuit module can be reduced.

### BRIEF DESCRIPTION OF THE DRAWINGS

Fig. 1 is a sectional view of an electronic circuit module according to an embodiment of the present invention;
Figs. 2A to 2D are sectional views showing a manufacturing process of the electronic circuit module; and
Fig. 3 is a flowchart of the manufacturing process of the electronic circuit module.

### DESCRIPTION OF THE PREFERRED EMBODIMENT

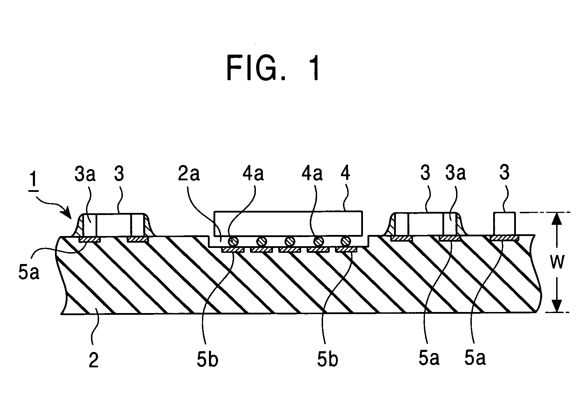

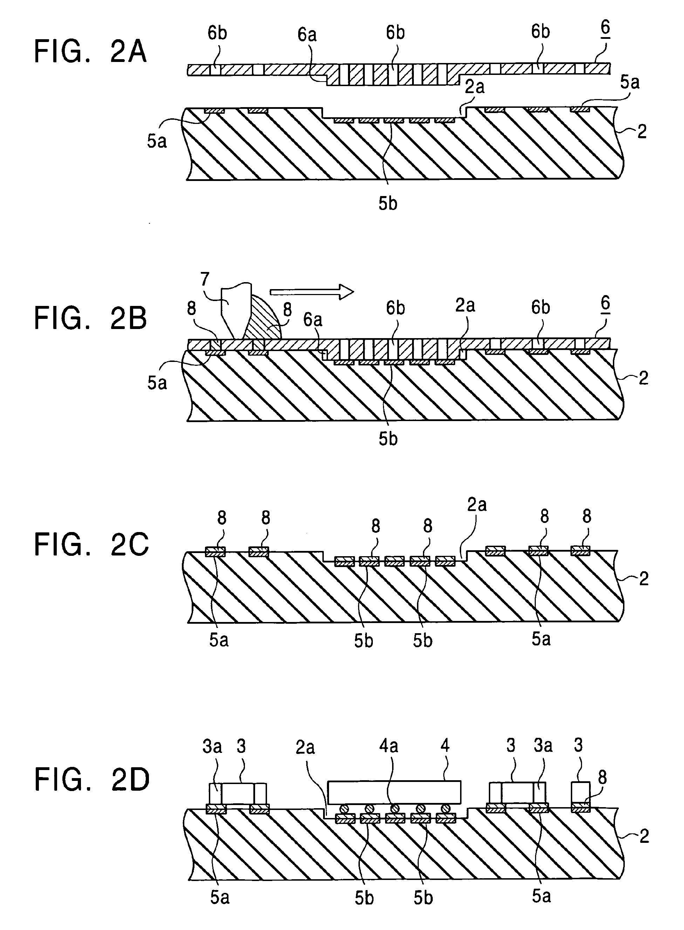

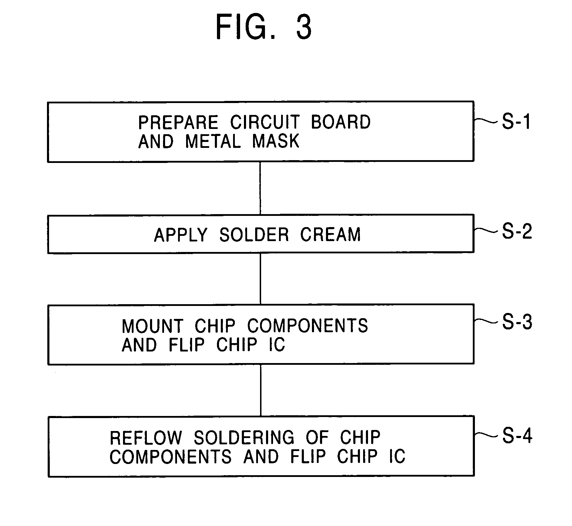

An embodiment of the present invention will be described below with reference to the accompanying drawings. Fig. 1 is a sectional view of an electronic circuit module according to an embodiment of the present invention, Figs. 2A to 2D are sectional views showing a manufacturing process of the electronic circuit module, and Fig. 3 is a flowchart of the manufacturing process of the electronic circuit module.

As shown in Fig. 1, an electronic circuit module 1 according to the present embodiment includes a circuit board 2 which is composed of an alumina substrate or a ceramic substrate and which has a recess 2a in the top surface thereof and various kinds of chip components 3 and a flip chip IC 4 which are mounted on the circuit board 2. The chip components 3 and the flip chip IC 4 are reflow-soldered on lands 5 which are arranged on the top surface of the circuit board 2 and the bottom surface of the recess 2a.

The circuit board 2 serves as a surface mount module which can be mounted on a motherboard (not shown) by reflow soldering, and is provided with a plurality of connecting terminals (not shown) which are to be reflow-soldered on connection lands arranged on the motherboard on the side and the bottom surfaces of the circuit board 2. The size of the recess 2a formed in the top surface of the circuit board 2 is slightly larger than the external size of the flip chip IC 4, and the depth thereof is about 0.2 mm to 0.3 mm. A plurality of lands 5 are arranged on the top surface of the circuit board 2 and the bottom surface of the recess 2a, and each land is electrically connected to a wiring pattern (not shown). For illustration, the lands arranged on the top surface of the circuit board 2 are denoted by 5a and the lands arranged on the bottom surface of the recess 2a are denoted by 5b.

Each of the chip components 3 may be a chip capacitor or a chip resistor, and external terminals 3a of the chip components 3 are reflow-soldered on the lands 5a on the top surface of the circuit board 2. The flip chip IC 4 is of a BGA type or a BCC type. In the present embodiment, the flip chip IC 4 is of the BGA type in which external connection lands are arranged on the bottom surface of the flip chip IC 4 in a grid pattern and solder balls 4a are adhered on the external connection lands. The solder balls 4a of the flip chip IC 4 are reflow-soldered on the lands 5b arranged on the bottom surface of the recess 2a.

Next, a method for manufacturing the electronic circuit module 1 having the above-described construction will be described below with reference to Figs. 2A to 2D and 3.

First, in Step 1 of the flowchart shown in Fig. 3, the circuit board 2 and a metal mask 6 are prepared. As described above, the circuit board 2 has the recess 2a in the top surface thereof, and the lands 5a and 5b are provided on the top surface of the circuit board 2 and the bottom surface of the recess 2a, respectively. In addition, as shown in Fig. 2A, the metal mask 6 has a projection 6a on the bottom surface thereof, and a plurality of through holes 6b are provided in the metal mask 6 in a region including the projection 6a. The projection 6a and the through holes 6b are formed by etching or laser processing, and the amount by which the projection 6a projects is set the same as the depth of the recess 2a formed in the circuit board 2 (0.2 mm to 0.3 mm).

Next, in Step 2 of the flowchart shown in Fig. 3, solder cream 8 is applied to each of the lands 5a and 5b provided on the circuit board 2 using the metal mask 6. In this step, first, the metal mask 6 is placed on the circuit board 2 and is positioned with respect to the circuit board 2 such that the projection 6a is inserted into the recess 2a. Then, as shown in Fig. 2B, the solder cream 8 is supplied into the through holes 6b in the metal mask 6 with a squeegee 7. Then, the metal mask 6 is removed from the circuit board 2. Accordingly, as shown in Fig. 2C, the solder cream 8 is applied to each of the lands 5a and 5b provided on the circuit board 2. Since the metal mask 6 has the projection 6a which comes into contact with the bottom surface of the recess 2a, the solder cream 8 can be applied to the lands 5a and 5b provided on the top surface of the circuit board 2 and the bottom surface of the recess 2a, respectively, at the same time.

Next, in Step 3 of the flowchart shown in Fig. 3, the chip components 3 and the flip chip IC 4 are mounted on the lands 5a and 5b, respectively, with the solder cream 8 provided therebetween. In this step, as shown in Fig. 2D, the chip components 3 are placed on the solder cream 8 applied to the lands 5a provided on the top surface of the circuit board 2 and the flip chip IC 4 is placed on the solder cream 8 applied to the lands 5b provided on the bottom surface of the recess 2a.

Next, in Step 4 of the flowchart shown in Fig. 3, the chip components 3 and the flip chip IC 4 are reflow-soldered on the corresponding lands 5a and 5b, and thus the electronic circuit module 1 shown in Fig. 1 is completed. More specifically, the circuit board 2 on which the chip components 3 and the flip chip IC 4 are placed is put in a reflow oven (not shown), and the solder cream 8 is melted and solidified in the reflow oven so that the external terminals 3a of the chip components 3 are reflow-soldered on the lands 5a arranged on the top surface of the circuit board 2 and the solder balls 4a of the flip chip IC 4 are reflow-soldered on the lands 5b arranged on the bottom surface of the recess 2a, as shown in Fig. 1.

As described above, in the electronic circuit module 1 according to the present embodiment, the recess 2a is formed in the top surface of the circuit board 2 and the solder balls 4a of the flip chip IC 4 are reflow-soldered on the lands 5b arranged on the bottom surface of the recess 2a. Accordingly, the amount by which the flip chip IC 4 projects from the surface of the circuit board 2 can be reduced by the amount corresponding to the depth of the recess 2a. Therefore, although the flip chip IC 4, which has a greater height than the chip components 3, is mounted on the circuit board 2 along with the chip components 3, the thickness of the electronic circuit module 1 (indicated by W in Fig. 1) is relatively small. In addition, when the electronic circuit module 1 is manufactured, the metal mask 6 having the projection 6a on the back surface thereof is used and the solder cream 8 is applied while the projection 6a is in contact with the bottom surface of the recess 2a. Therefore, the solder cream 8 can be applied to the lands 5a provided on the top surface of the circuit board 2 and the lands 5b provided on the bottom surface of the recess 2a at the same time. Since the solder cream 8 is applied to the lands 5a and 5b on the circuit board 2 at the same time using the metal mask 6 and the chip components 3 and the flip chip IC 4 are placed on the solder cream 8 and reflow-soldered on the lands 5a and 5b, respectively, all of the chip components 3 and the flip chip IC 4 can be mounted on the circuit board 2 in a single reflow-soldering process. Therefore, it is not necessary to use an expensive and complex mounting machine as in the case where an IC bare chip is attached by wire bonding or with stud bumps, and the inexpensive, low-profile electronic circuit module 1 can be manufactured at low cost.

In the above-described embodiment, the flip chip IC 4 of the BGA type is described as an example of the surface-mount electronic component which is reflow-soldered in the recess 2a of the circuit board 2. However, a flip chip IC of the BCC type and a surface-mount electronic component other than the flip chip IC may also be used.

## Claims

1. An electronic circuit module comprising:
a circuit board having a recess in a surface of the circuit board;
lands which are arranged on the surface of the circuit board and the bottom surface of the recess; and
surface-mount electronic components which are reflow-soldered on the lands.

2. An electronic circuit module according to Claim 1, wherein the surface-mount electronic components include chip components which are soldered on the surface of the circuit board and a flip chip IC which is soldered on the bottom surface of the recess.

3. A method for manufacturing an electronic circuit module comprising the steps of:
forming a recess in a surface of a circuit board;
providing lands on the surface of the circuit board and the bottom surface of the recess;
placing a metal mask on the surface of the circuit board, the metal mask having a flat top surface and a bottom surface provided with a projection, and positioning the projection with respect to the recess;
applying solder cream to each of the lands through the metal mask;
placing surface-mount electronic components on the lands with the solder cream interposed between each of the surface-mount electronic components and the corresponding lands; and
putting the circuit board in a reflow oven and reflow-soldering the surface-mount electronic components to the corresponding lands.
